# EUROPÄISCHE PATENTSCHRIFT

(11) **EP 2 938 796 B1**
(45) Veröffentlichungstag und Bekanntmachung des Hinweises auf die Patenterteilung: **12.02.2020**
(21) Anmeldenummer: 13840162.5
(22) Anmeldetag: 23.12.2013
(51) Int. Cl.: E05B 85/02, E05B 81/54, H05K 5/00, H05K 7/02

(54) **KOMPONENTENTRÄGER FÜR ELEKTRISCHE/ELEKTRONISCHE BAUTEILE**
COMPONENT CARRIER FOR ELECTRICAL/ELECTRONIC COMPONENTS
SUPPORT POUR COMPOSANTS ÉLECTRIQUES OU ÉLECTRONIQUES

(30) Priorität: 27.12.2012 DE 202012105072 U
(43) Veröffentlichungstag der Anmeldung: 04.11.2015
(73) Patentinhaber: Kiekert Aktiengesellschaft, 42579 Heiligenhaus (DE)
(72) Erfinder: KOCH, Asmus, 50678 Köln (DE); HEINZEN, Inga, 47807 Krefeld (DE); FASSEL, Jan, Nejdek 362 22 (CZ); SUK, Jan, Cechtice 257 65 (CZ)
(86) Internationale Anmeldenummer: PCT/DE2013/000823
(87) Internationale Veröffentlichungsnummer: WO 2014/101914

(56) Entgegenhaltungen:
- DE-A1-102008 015 627
- DE-A1-102009 036 128
- JP-A- H 037 011
- JP-A- S5 659 488
- JP-A- H06 351 132
- JP-A- 2002 044 835
- JP-A- 2005 323 441

## Beschreibung

Die Erfindung betrifft einen Komponententräger für elektrische/elektronische Bauteile gemäß dem Oberbegriff des Anspruchs 1.

Bei einem Komponententräger des eingangs beschriebenen Aufbaus entsprechend der DE 10 2005 049 975 C5 handelt es sich um ein Schlossgehäuse eines Kraftfahrzeugtürverschlusses. Dieses weist wenigstens ein Basiselement auf. Das Leiterbahngebilde ist aus Weißblech hergestellt, bei welchem es sich um ein kaltgewalztes Stahlblech mit einer Dicke von bis zu 0,5 mm handelt. Außerdem ist eine weißschimmernde Zinnschicht von mindestens 5 µm elektrolytisch aufgebracht. Auf diese Weise wird eine kostengünstige und robuste Auslegung eines Komponententrägers zur Verfügung gestellt.

Vergleichbare Komponententräger werden in der DE 101 39 356 A1 oder auch der DE 20 2010 009 708 U1 beschrieben.

Wie üblich dient der Komponententräger dazu, elektrische und/oder elektronische Bauteile auf seinem Trägerelement aufzunehmen und mit Hilfe des Leiterbahngebildes untereinander bzw. mit einer entfernten Steuereinheit oder anderen elektrischen Elementen zu verbinden. Zu diesem Zweck wird der gesamte Komponententräger nach der Bestückung mit den elektrischen bzw. elektronischen Bauteilen typischerweise mit einer Vergussmasse umhüllt, um ihn vor Umwelteinflüssen zu schützen. Bei dem Leiterbahngebilde handelt es sich regelmäßig um ein Stanzgitter, welches die verschiedenen Leiterbahnen zusammenfasst und deren gemeinsame Herstellung ermöglicht. Zusammen mit dem Trägerelement bzw. den elektrischen/elektronischen Bauteilen wird das Leiterbahngebilde nach der Bestückung durch die Vergussmasse größtenteils oder gänzlich verschlossen. Diese Vorgehensweise hat sich prinzipiell bewährt.

Im Stand der Technik bzw. in der Praxis wird generell das Ziel verfolgt, die Materialstärke des eingesetzten Leiterbahngebildes aus Kostengründen so gering wie möglich einzustellen. Die Lehre entsprechend der DE 10 2005 049 975 C5 arbeitet an dieser Stelle mit Weißblech einer Dicke von lediglich bis zu 0,5 mm. Dem Trend zur Materialersparnis zuwider treten jedoch mit immer geringer werdender Materialstarke zunehmend Montageprobleme auf. Tatsächlich beobachtet man insbesondere bei der Kontaktierung von Motoren oder anderen voluminösen und gewichtigen elektrischen bzw. elektronischen Bauteilen mit dem Leiterbahngebilde Probleme dergestalt, dass abgewinkelte Fahnen des Leiterbahngebildes unbeabsichtigt umgebogen werden. Das kann sogar noch während des Betriebes durch zwangsläufige Bewegungen des Motors auftreten. Als Folge hiervon werden in der Praxis Kontaktprobleme festgestellt, die insbesondere nach einer bestimmten Betriebszeit besonders problematisch sind und nur aufwendig beherrscht werden können. Hier will die Erfindung insgesamt Abhilfe schaffen.

JP H06 351 132 A, JP H03 7011 A, JP 2005 323 441 A, DE 10 2009 036 128 A1, JP 2002 044 835 A und JP S56 59 488 A beschreiben jeweils einen Komponententräger mit einem Trägerelement und einem mit dem Trägerelement verbindbaren Leiterbahngebilde aus einzelnen metallischen Leiterbahnen,wobei zumindest eine Leiterbahn des Leiterbahngebildes bereichsweise eine Mehrfachlage oder Doppellage aufweist.

Der Erfindung liegt das technische Problem zugrunde, einen derartigen Komponententräger so weiterzuentwickeln, dass aktuelle und zukünftige Kontaktprobleme praktisch nicht mehr auftreten und eine dauerhaft einwandfreie Funktionsweise gewährleistet ist.

Zur Lösung dieser technischen Problemstellung schlägt die Erfindung einen Komponententräger gemäß Anspruch 1 vor.

Der erfindungsgemäße Komponententräger weist ein eine Motoraufnahme oder Motorwanne aufweisendes Trägerelement und ein mit dem Trägerelement verbindbares Leiterbahngebilde aus einzelnen metallischen Leiterbahnen auf, wobei zumindest eine Leiterbahn des Leiterbahngebildes bereichsweise eine Mehrfachlage und insbesondere eine Doppellage aufweist. Außerdem ist lediglich die zumindest eine zur Kontaktierung eines in die Motoraufnahme oder Motorwanne plazierbaren Elektromotors vorgesehene Leiterfahne des Leiterbahngebildes als Mehrfachlage oder Doppellage ausgebildet.

Nach vorteilhafter Ausgestaltung ist die wenigstens eine Leiterbahn im Bereich einer Leiterfahne mit der Mehrfachlage und insbesondere der Doppellage ausgerüstet.

Die fragliche Leiterfahne ist im Allgemeinen winklig und insbesondere rechtwinklig im Vergleich zu einer Hauptebene des Leiterbahngebildes angeordnet. Auf diese Weise fungiert die Leiterfahne typischerweise als gegenüber der

Hauptebene des Leiterbahngebildes vorstehender Stecker bzw. Steckkontakt, auf den beispielsweise eine Buchse aufgesteckt werden kann. Ebenso ist es möglich, die Leiterfahne mit einem Kontakt des betreffenden elektrischen/ elektronischen Bauteils zu verlöten. Im Regelfall dient die fragliche Leiterfahne zur Kontaktierung eines Elektromotors. Lediglich diese zur Kontaktierung des betreffenden Elektromotors vorgesehene Leiterfahne des Leiterbahngebildes ist im Rahmen der Erfindung als Mehrfachlage und insbesondere Doppellage ausgebildet.

Auf die Weise trägt die Erfindung dem Umstand Rechnung, dass gerade die Leiterfahnen zur Kontaktierung von Elektromotoren den zuvor bei der Würdigung des Standes der Technik beschriebenen spezifischen mechanischen Beanspruchungen ausgesetzt sind. Um diese mechanischen Beanspruchungen und insbesondere ein Abbiegen, Abknicken oder sogar ein Abbrechen der Leiterfahne in diesem Zusammenhang zu begegnen, ist die betreffende Leiterfahne erfindungsgemäß als Mehrfachlage und insbesondere Doppellage ausgebildet.

Hierbei trägt die Erfindung ergänzend dem Umstand Rechnung, dass das Leiterbahngebilde bevorzugt mit einer durchgängigen Materialstärke von weniger als 0,5 mm und insbesondere 0,4 mm und weniger ausgebildet ist. Durch die Auslegung der Leiterfahne als Mehrfachlage und insbesondere Doppellage wird in diesem Bereich demgegenüber mindestens die doppelte Materialstärke beobachtet, die im Allgemeinen 0,8 mm und sogar 1 mm beträgt oder betragen kann. Infolge dieser erhöhten Materialstärke im Bereich der Leiterfahne zum Anschluss des Elektromotors werden sämtliche mechanische Belastungen nicht nur bei der Montage sondern auch beim anschließenden Betrieb während der gesamten Lebensdauer aufgenommen und beherrscht. Die Funktionssicherheit gegenüber bisherigen Komponententrägern ist also deutlich gesteigert.

Um dies im Detail zu erreichen, ist die Mehrfachlage bzw. Doppellage typischerweise als Falz mit an einer Faltkante abgekantetem sowie angefaltetem Umschlag ausgebildet. Das heißt, bei der Herstellung der Doppellage als Falz wird zunächst die betreffende Leiterbahn an der Faltkante abgekantet, meistens unter Berücksichtigung eines in etwa rechtwinkligen Biegewinkels. Diese Abkantung wird nun mit einem Umschlag ausgerüstet, das heißt die Abkantung wird auf sich unter Berücksichtigung eines Biegewinkels von ca. 180 ° zurückgebogen bzw. in der Art des solchermaßen gebildeten Umschlags an die Abkantung angefaltet. Dadurch entsteht der bereits angesprochene Falz.

Als Folge hiervon beobachtet man im Rahmen der Erfindung im Bereich der Mehrfachlage bzw. Doppellage eine abgerundete Frontkante, so dass etwaige Verletzungen beim Aufstecken einer Buchse auf diese Doppellage bzw. die entsprechend ausgelegte Leiterfahne schon von vornherein vermieden bzw. ausgeschlossen werden können.

Neben dieser Doppelung bzw. Mehrfachlage im Bereich der Leiterfahne der fraglichen Leiterbahn hat es sich darüber hinaus bewährt, wenn die fragliche Mehrfachlage bzw. Doppellage mit jeweils einem Anschlusssteg ausgebildet ist. Tatsächlich ist die Mehrfachlage und insbesondere Doppellage mit jeweils einem beidseitigen Anschlusssteg ausgerüstet. Dadurch verfügt die fragliche Leiterfahne zum Anschluss des Elektromotors über einen Ω-artigen Querschnitt, bei dem die beiden Ω-Schenkei aneinander anliegen und die Ω-Füße die jeweiligen beidseitigen Anschlussstege definieren.

Da diese Anschlussstege im Regelfall am Komponententräger festgelegt sind, beispielsweise durch eine Vorfixierung oder ein Vorumspritzen, verfügt die entsprechend ausgerüstete Leiterfahne über eine besonders hohe Stabilität und wird ein Abknicken, Verbiegen, ein Abbrechen etc. zuverlässig verhindert.

Das gilt sogar schon für den Fall, dass das Leiterbahngebilde insgesamt aus Messing hergestellt ist, also einem relativ weichen und kaltverformbaren Metall. Erst recht kann diese Forderung erfüllt werden, wenn für die Herstellung des Leiterbahngebildes alternativ Weißblech oder dergleichen ggf. mit einer Zinnbeschichtung als Korrosionsschutz zum Einsatz kommt. Im Regelfall setzt die Erfindung an dieser Stelle jedoch Messing ein.

Dabei hat sich herausgestellt, dass trotz der Fertigung des gesamten Leiterbahngebildes aus Messing mit einer Materialstärke von weniger als 0,5 mm und insbesondere von 0,4 mm und weniger dennoch die erforderliche Stabilität und Steifigkeit an neuralgischen Punkten zur Verfügung gestellt werden kann. Bei diesen neuralgischen Punkten handelt es sich um die Leiterfahnen zur Kontaktierung des (jeweiligen) Elektromotors. Diese Leiterfahnen des Leiterbahngebildes sind erfindungsgemäß als Mehrfachlagen und insbesondere Doppellagen ausgebildet, wie dies im Detail beschrieben worden ist. Dadurch kombiniert die Erfindung zugleich ein Maximum an Materialersparnis mit der erforderlichen Funktionssicherheit über die gesamte Lebensdauer gesehen. Das war bisher nicht für möglich gehalten worden. Hierin sind demzufolge die besonderen Vorteile zu sehen.

Im Folgenden wird die Erfindung anhand lediglich ein Ausführungsbeispiel darstellenden Zeichnung näher erläutert; es zeigen:
- **Fig. 1**: einen erfindungsgemäßen Komponententräger für elektrische/ elektronische Bauteile in Gestalt eines Schlossgehäuses eines Kraftfahrzeugtürverschlusses perspektivisch und
- **Fig. 2**: das im Rahmen der Fig. 1 eingesetzte Leiterbahngebilde im Detail ebenfalls in einer Perspektive.

In den Figuren ist ein Komponententräger für elektrische/elektronische Bauteile 1, 2, 3 dargestellt. Bei dem Komponententräger handelt es sich im Beispielfall um den Bestandteil eines Schlossgehäuses 4 eines nicht näher gezeigten Kraftfahrzeugtürverschlusses, welches insofern als Trägerelement 4 fungiert. Grundsätzlich kann der Komponententräger aber auch unabhängig von dem Schlossgehäuse 4 in dessen Innern aufgenommen und platziert werden. Das ist jedoch nicht dargestellt. Das heißt, im Rahmen des Ausführungsbeispiels sind das Trägerelement 4 und das Schlossgehäuse 4 synonym bzw. stellt der Komponententräger einen Bestandteil des Schlossgehäuses 4 des fraglichen Kraftfahrzeugtürverschlusses dar, wobei das Schlossgehäuse 4 ganz oder teilweise als Trägerelement 4 des Komponententrägers fungiert.

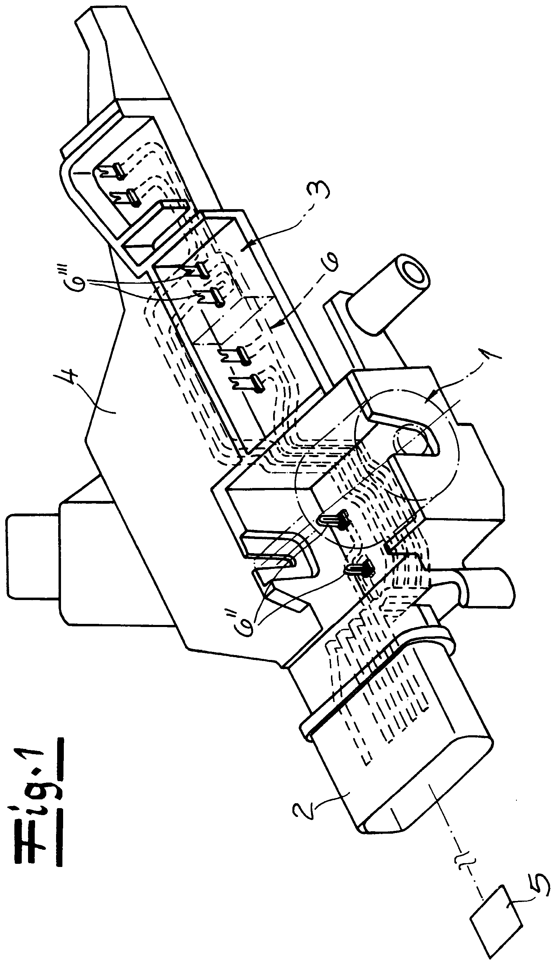

Bei den elektrischen/elektronischen Bauteilen 1, 2, 3 handelt es sich um einen nur angedeuteten Elektromotor 1, der in einer zugehörigen Motoraufnahme oder Motorwanne platziert ist. Darüber hinaus erkennt man in der Fig. 1 ansatzweise eine Buchse 2 zur Aufnahme eines nicht dargestellten Steckers, mit dessen Hilfe die fraglichen elektrischen/elektronischen Bauteile 1, 2, 3 mit einer entfernt angeordneten und lediglich angedeuteten Steuereinheit 5 elektrisch verbunden werden.

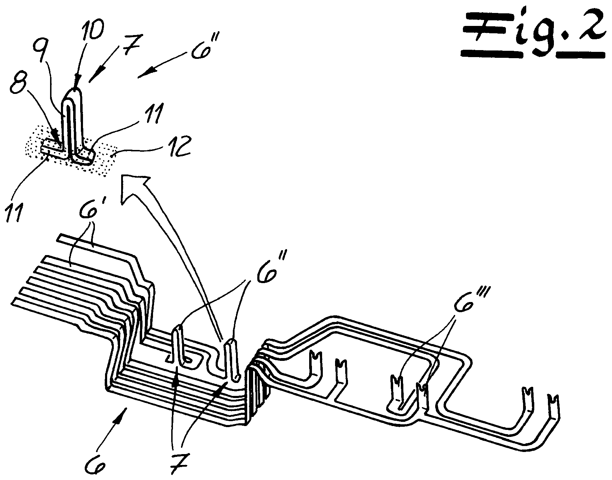

Bei dem elektrischen bzw. elektronischen Bauteil 3 handelt es sich schließlich um einen Mikroschalter 3, der in der Fig. 1 exemplarisch angedeutet ist und beispielsweise einzelne Funktionsstellungen von mechanischen Elementen des Kraftfahrzeugtürverschlusses abfragt. Die zuvor erläuterten und nur beispielhaft sowie nicht abschließend dargestellten und beschriebenen elektrischen/elektronischen Bauteile 1, 2, 3 werden insgesamt von dem Schlossgehäuse 4 getragen bzw. aufgenommen, das diesbezüglich als Trägerelement 4 fungiert. Mit dem Trägerelement 4 ist ein im Detail in der Fig. 2 dargestelltes Leiterbahngebilde 6 verbindbar.

Das Leiterbahngebilde 6 weist einzelne metallische Leiterbahnen 6' auf und zusätzlich angedeutete Leiterfahnen 6" sowie 6''' als jeweilige Bestandteile der zugehörigen Leiterbahn 6'. Die Leiterfahnen 6" dienen zur Kontaktierung des Elektromotors 1. Demgegenüber sind die Leiterfahnen 6''' zur Kontaktierung des Mikroschalters 2 vorgesehen.

Anhand der Fig. 2 sowie der vergrößerten Ausschnittszeichnung in der Fig. 2 erkennt man, dass erfindungsgemäß zumindest zwei Leiterbahnen 6' des Leiterbahngebildes 6 eine Mehrfachlage und insbesondere Doppellage 7 aufweisen. Die betreffende Leiterfahne 6" bzw. 6''' ist jeweils winklig und insbesondere rechtwinklig im Vergleich zu einer Hauptebene des Leiterbahngebildes 6 angeordnet. Die Hauptebene des Leiterbahngebildes 6 wird von den größtenteils horizontal verlaufenden Leiterbahnen 6' aufgespannt. Demgegenüber erstrecken sich die Leiterfahnen 6" und 6''' winklig und insbesondere rechtwinklig gegenüber der genannten horizontalen Hauptebene.

Anhand der vergrößerten Darstellung in Fig. 2 erkennt man, dass die Mehrfachlage bzw. Doppellage 7 als Falz ausgebildet ist. Der Falz wird dadurch gebildet, dass die betreffende Leiterbahn 6' zunächst an einer Falzkante 8 abgekantet wird, und zwar überwiegend rechtwinklig. Auf diese Weise wird eine Abkantung 9 definiert. Die Abkantung 9 dient nun als Ausgangspunkt für einen Umschlag 10, indem die Abkantung 9 auf sich selbst unter Berücksichtigung eines Biegewinkels von ca. 180 ° zurückgebogen und an die Abkantung 9 angefaltet wird. Auf diese Weise wird der bereits angesprochene Umschlag 10 definiert und beschrieben.

Dadurch weist die Leiterfahne 6" einen Q-artigen Querschnitt auf, wie dies die vergrößerte Darstellung in der Fig. 2 unmittelbar deutlich macht. Zugleich erkennt man jeweilige Anschlussstege 11 beidseitig des Umschlages 10. Diese Anschlussstege 11 sind typischerweise im Zuge der Herstellung des Komponententrägers in ein auf das Trägerelement 4 aufgebrachtes Material 12 eingebettet worden, bei dem es sich im Regelfall um ein Adhäsiv- bzw. Dichtmaterial 12 handelt. Das Adhäsiv- bzw. Dichtmaterial 12 wird im Zuge einer sogenannten Vorumspritzung auf das Trägerelement 4 aufgebracht, um das zuvor aufgelegte bzw. eingelegte Leiterbahngebilde 6 zu fixieren.

Durch das Adhäsiv- bzw. Dichtmaterial 12 und die hierin verankerten Anschlussstege 11 sowie in Verbindung mit dem Umschlag 10 bzw. der hierdurch realisierten Doppellage 7 im Bereich der Leiterfahne 6" kann der Elektromotor 1 einwandfrei und beschädigungslos, das heißt ohne Umknicken oder Abbrechen der fraglichen Leiterfahne 6", kontaktiert werden. Auch ist hierdurch eine dauerhafte elektrische Verbindung gewährleistet.

Das Leiterbahngebilde 6 verfügt durchgängig über eine Materialstärke von typischerweise weniger als 0,5 mm und insbesondere 0,4 mm und weniger. Dadurch wird eine erhebliche Materialersparnis gegenüber bisherigen Leiterbahngebilden 6 zur Verfügung gestellt. Hinzu kommt, dass durch die Doppellage bzw. Mehrfachlage 7 im Bereich der Leiterfahne 6" für den Elektromotor 1 an dieser Stelle die wenigstens doppelte Materialstärke von ca. 0,8 mm und mehr beobachtet wird. Dadurch verfügt die fragliche Leiterfahne 6" über die nötige Stabilität und Steifigkeit damit mechanische Beschädigungen wie zuvor beschrieben nicht stattfinden können.

Das Leiterbahngebilde 6 selbst ist im Regelfall aus Messing hergestellt. Grundsätzlich kann das Leiterbahngebilde 6 aber auch aus Weißblech hergestellt werden. Im Übrigen handelt es sich bei dem Leiterbahngebilde 6 im Regelfall um ein Stanzteil, welches im Zuge der Stanzung oder auch danach mit der beschriebenen Mehrfachlage bzw. Doppellage 7 zumindest im Bereich der Leiterfahnen 6" zum Anschluss des Elektromotors 1 ausgerüstet wird.

## Patentansprüche

1. Komponententräger für elektrische/elektronische Bauteile (1, 2, 3), beispielsweise zur Kombination mit einem Schlossgehäuse (4) oder als Bestandteil eines Schlossgehäuses (4) eines Kraftfahrzeugtürverschlusses, mit
• einem eine Motoraufnahme oder Motorwanne aufweisenden Trägerelement (4) und
• einem mit dem Trägerelement (4) verbindbaren Leiterbahngebilde (6) aus einzelnen metallischen Leiterbahnen (6'),
wobei
• zumindest eine Leiterbahn (6') des Leiterbahngebildes (6) bereichsweise eine Mehrfachlage und insbesondere Doppellage (7) aufweist, und
• lediglich die zumindest eine zur Kontaktierung eines in die Motoraufnahme oder Motorwanne plazierbaren Elektromotors (1) vorgesehene Leiterfahne (6") des Leiterbahngebildes (6) als Mehrfachlage oder Doppellage (7) ausgebildet ist.

2. Komponententräger nach Anspruch 1, **dadurch gekennzeichnet, dass** die Leiterbahn (6') im Bereich einer Leiterfahne (6", 6''') mit der Mehrfachlage oder Doppellage (7) ausgerüstet ist.

3. Komponententräger nach Anspruch 1 oder 2, **dadurch gekennzeichnet, dass** die Leiterfahne (6", 6''') winklig oder rechtwinklig im Vergleich zu einer Hauptebene des Leiterbahngebildes (6) angeordnet ist.

4. Komponententräger nach einem der Ansprüche 1 bis 3, **dadurch gekennzeichnet, dass** die Mehrfachlage oder Doppellage (7) als Falz mit an einer Faltkante (8) abgekantetem sowie angefaltetem Umschlag (10) ausgebildet ist.

5. Komponententräger nach einem der Ansprüche 1 bis 4, **dadurch gekennzeichnet, dass** die Mehrfachlage oder Doppellage (7) als Doppelung bzw. Doppellage mit jeweils beidseitigem Anschlusssteg (11) ausgebildet ist.

6. Komponententräger nach Anspruch 5, **dadurch gekennzeichnet, dass** die Mehrfachlage oder Doppellage (7) einen Ω-artigen Querschnitt aufweist.

7. Komponententräger nach einem der Ansprüche 1 bis 6, **dadurch gekennzeichnet, dass** das Leiterbahngebilde (6) eine durchgängige Materialstärke von weniger als 0,5 mm oder von 0,4 mm und weniger aufweist.

8. Komponententräger nach einem der vorigen Ansprüche, **dadurch gekennzeichnet, dass** das Leiterbahngebilde (6) aus Messing, Weißblech oder dergleichen hergestellt ist.

9. Komponententräger nach einem der vorigen Ansprüche, **dadurch gekennzeichnet, dass** es sich bei dem Leiterbahngebilde (6) um ein Stanzteil handelt.

## Claims

1. Component carrier for electrical/electronic components (1, 2, 3), for example to be combined with a latch housing (4) or as part of a latch housing (4) of a motor vehicle door lock, comprising
• a carrier element (4) comprising a motor receptacle or motor cradle and
• a conductor-track construction (6) which is made of individual metal conductor tracks (6') and can be connected to the carrier element (4),
wherein
• at least one conductor track (6') of the conductor-track construction (6) comprises, in regions, a multiple-layer structure and in particular a double-layer structure (7), and
• only the at least one conductor lug (6") of the conductor-track construction (6), which lug is provided for contacting an electric motor (1) that can be placed in the motor receptacle or motor cradle, is formed as a multiple-layer structure or double-layer structure (7).

2. Component carrier according to claim 1, **characterized in that** the conductor track (6') is equipped with the multiple-layer structure or double-layer structure (7) in the region of a conductor lug (6", 6''').

3. Component carrier according to either claim 1 or claim 2, **characterized in that** the conductor lug (6", 6''') is arranged at an angle or at a right angle compared to a main plane of the conductor-track construction (6).

4. Component carrier according to any of claims 1 to 3, **characterized in that** the multiple-layer structure or double-layer structure (7) is in the form of a fold which has a transitional region (10) which is bent or folded at a folding edge (8).

5. Component carrier according to any of claims 1 to 4, **characterized in that** the multiple-layer structure or double-layer structure (7) is formed as a doubled region or double layer having a connecting piece (11) on both sides.

6. Component carrier according to claim 5, **characterized in that** the multiple-layer structure or double-layer structure (7) has an Ω-like cross-section.

7. Component carrier according to any of claims 1 to 6, **characterized in that** the conductor-track construction (6) has a continuous material thickness of less than 0.5 mm or of 0.4 mm and less.

8. Component carrier according to any of the preceding claims, **characterized in that** the conductor-track construction (6) is made of brass, tinplate or the like.

9. Component carrier according to any of the preceding claims, **characterized in that** the conductor-track construction (6) is a stamped part.

## Revendications

1. Support de composants pour composants électriques/électroniques (1, 2, 3), par exemple destiné à être combiné avec un boîtier de serrure (4) ou à constituer une partie d'un boîtier de serrure (4) pour un système de fermeture de porte de véhicule à moteur, comportant
• un élément support (4) comportant un support de moteur ou un carter de moteur, et
• un ensemble de pistes conductrices (6) qui peut être relié à l'élément support (4), constitué de pistes conductrices (6') métalliques individuelles,
dans lequel
• au moins une piste conductrice (6') de l'ensemble de pistes conductrices (6) présente par endroits une structure multicouche et en particulier une structure à deux couches (7), et
• seule l'au moins une cosse conductrice (6") de l'ensemble de pistes conductrices (6) prévue pour mettre en contact un moteur électrique (1) qui peut être placé dans logement de moteur ou le bac de moteur est réalisée sous la forme d'une structure multicouche ou d'une structure à deux couches (7).

2. Support de composants selon la revendication 1, **caractérisé en ce que** la piste conductrice (6') est équipée d'une structure multicouche ou d'une structure à deux couches (7) dans la zone d'une cosse conductrice (6", 6").

3. Support de composants selon la revendication 1 ou 2, **caractérisé en ce que** la cosse conductrice (6", 6") est disposée selon un angle ou selon un angle droit par rapport à un plan principal de l'ensemble de pistes conductrices (6).

4. Support de composants selon l'une des revendications 1 à 3, **caractérisé en ce que** la structure multicouche ou la structure à deux couches (7) est réalisée sous la forme d'un pli comportant une enveloppe (10) chanfreinée et repliée au niveau d'un bord de pliage (8).

5. Support de composants selon l'une des revendications 1 à 4, **caractérisé en ce que** la structure multicouche ou la structure à deux couches (7) est réalisée sous la forme d'une doublure ou d'une structure à deux couches comportant respectivement une traverse de liaison (11) des deux côtés.

6. Support de composants selon la revendication 5, **caractérisé en ce que** la structure multicouche ou la structure à deux couches (7) comporte une section transversale de type Ω.

7. Support de composants selon l'une des revendications 1 à 6, **caractérisé en ce que** l'ensemble de pistes conductrices (6) a une épaisseur de matériau continue inférieure à 0,5 mm ou de 0,4 mm et moins.

8. Support de composants selon l'une des revendications précédentes, **caractérisé en ce que** l'ensemble de pistes conductrices (6) est constitué de laiton, de fer blanc ou d'un matériau similaire.

9. Support de composants selon l'une des revendications précédentes, **caractérisé en ce que** l'ensemble de pistes conductrices (6) est une pièce emboutie.
